# EUROPEAN PATENT APPLICATION

(11) **EP 4 831 883 A1**
(43) Date of publication of application: **28.10.2026**
(21) Application number: 26173890.0
(22) Date of filing: 22.04.2026
(51) Int. Cl.: G06Q 10/04, G06Q 50/40

(54) **AIRCRAFT EMISSIONS PREDICTION SYSTEM AND METHOD**

(30) Priority: 22.04.2025 US 202519186454
(71) Applicant: The Boeing Company, Arlington, VA 22202 (US)
(72) Inventor: ASHOK, Rahul, SINGAPORE (SG); KUMAR, Shambhavvi Senthil, SINGAPORE (SG); ANG, Keng Boon, SINGAPORE (SG)
(74) Representative: Plasseraud IP

(57) **Abstract**

Aircraft emissions prediction systems and methods are described herein. The systems and methods estimate aircraft emissions using non-proprietary data and predictive modeling. The technical problem addressed is the difficulty in accessing proprietary emissions data, which is important for regulatory compliance and operational efficiency. The solution involves a method and system that receive aircraft and flight position data from non-proprietary databases, calculate a gross weight prediction using a weight prediction model, and subsequently calculate an emissions prediction using an emissions prediction model. This approach enables precise emissions estimation without reliance on proprietary data, facilitating informed decision-making for stakeholders such as airlines, regulators, and airports. The primary use of the technology is to provide accurate emissions data for benchmarking environmental performance and optimizing flight operations.

## Description

### FIELD OF THE DISCLOSURE

The subject matter described herein relates to environmental monitoring technologies, specifically to systems and methods for estimating aircraft emissions using non-proprietary data and predictive modeling.

### BACKGROUND OF THE DISCLOSURE

In the aviation industry, accurately estimating aircraft emissions plays an important role in regulatory compliance, environmental impact assessments, and operational efficiency. Traditionally, emissions estimation relies on datasets provided by airlines or aircraft manufacturers. These datasets, while potentially accurate, are often difficult to access due to confidentiality agreements and complex approval processes for release of the information. This lack of accessibility poses significant challenges for stakeholders such as regulators, airlines, airports, and fuel vendors who require precise emissions data for various applications, including benchmarking environmental performance, ensuring compliance, and optimizing fuel distribution.

Existing solutions, such as those provided by industry-standard tools, often depend on generalized assumptions like the minimal distance between origin and destination locations of a flight, which can lead to imprecise emissions calculations. These methods fail to account for the specific operational characteristics of individual flights, which are important for accurate emissions estimation. As a result, there is a need for a more accessible and precise method of estimating aircraft emissions that can operate independently of proprietary data, thereby enabling a broader range of stakeholders to make informed decisions based on reliable emissions data.

### SUMMARY OF THE DISCLOSURE

According to a first aspect of the present subject disclosure, a method is proposed, which comprises receiving aircraft data; receiving flight position data; calculating a gross weight prediction of an aircraft using the aircraft data and the flight position data that are input into a weight prediction model; and calculating an emissions prediction of the aircraft using the aircraft data, the flight position data, and the gross weight prediction that are input into an emissions prediction model.

In one or more embodiments, the aircraft data may be received from a first non-proprietary database, and the flight position data may be received from one or more of the first non-proprietary database and a second non-proprietary database.

In some embodiments, the aircraft data may comprise non-proprietary aircraft metadata for the aircraft. In some embodiments, the flight position data may comprise non-proprietary automatic dependent surveillance-broadcast, ADS-B, position data for one or more flights of the aircraft.

In one or more embodiments, the proposed method may further comprise: receiving a gross aircraft weight from an aircraft communications addressing and reporting system, ACARS; comparing the gross aircraft weight with the gross weight prediction to identify a first error; modifying the weight prediction model using the first error; receiving an emissions value from the ACARS; comparing the emissions value with the emissions prediction to identify a second error; and modifying the emissions prediction model using the second error.

In one or more embodiments, the proposed method may further comprise: automatically changing flight of the aircraft based on the emissions prediction that is calculated.

In one or more embodiments, the aircraft data and the flight position data may be publicly available information.

In one or more embodiments, the aircraft data may include aircraft metadata. In some embodiments, the aircraft metadata may include one or more of: an aircraft engine type, a fuel capacity of the aircraft, a payload limit of the aircraft, an age of the aircraft, an operating empty weight of the aircraft, and a number of seats onboard the aircraft.

In one or more embodiments, the flight position data may include automatic dependent surveillance-broadcast (ADS-B) position data.

In one or more embodiments, the flight position data may include one or more of a flight origin location, a flight destination location, and a historical average flight time from the flight origin location to the flight destination location.

In one or more embodiments, the flight position data may include a historical average first level-off altitude for historical flights between the flight origin location to the flight destination location.

In one or more embodiments, the proposed method may further comprise: receiving a gross aircraft weight from an aircraft communications addressing and reporting system (ACARS); comparing the gross aircraft weight with the gross weight prediction to identify an error; and modifying the weight prediction model using the error.

In one or more embodiments, the proposed method may further comprise: receiving an emissions value from an aircraft communications addressing and reporting system (ACARS); comparing the emissions value with the emissions prediction to identify an error; and modifying the emissions prediction model using the error.

According to another aspect of the present subject disclosure, an emissions prediction system is proposed, which comprises: a controller configured to receive aircraft data from a first non-proprietary database and to receive flight position data from one or more of the first non-proprietary database and a second non-proprietary database; and one or more tangible and non-transitory computer readable storage media storing a weight prediction model and an emissions prediction model, the controller configured to input the aircraft data and the flight position data into the weight prediction model, the weight prediction model configured to output a gross weight prediction of an aircraft, the controller configured to input the aircraft data, the flight position data, and the gross weight prediction into the emissions prediction model, the emissions prediction model configured to output an emissions prediction of the aircraft.

In one or more embodiments, the proposed emissions prediction system may be configured to implement any of the methods proposed in the present subject disclosure.

In one example, a method includes receiving aircraft data from a non-proprietary database and receiving flight position data from one or more non-proprietary sources. The method further involves predicting a gross weight of an aircraft by inputting the received data into a weight prediction model and then predicting emissions generated by the aircraft by inputting the aircraft data, flight position data, and the gross weight prediction into an emissions prediction model. In some implementations, the method further includes automatically changing the flight of the aircraft based on the emissions prediction. Additional features include the use of publicly available information where the aircraft data may comprise metadata such as an aircraft engine type, fuel capacity, payload limit, age, operating empty weight, or a number of seats onboard, and the flight position data may include automatic dependent surveillance-broadcast information such as a flight origin, a flight destination, a historical average flight time, or a historical average first level-off altitude. The method may also involve receiving a gross aircraft weight and an emissions value from an aircraft communications addressing and reporting system. This weight and/or value can be used as ground truths or target values for initially training the models. Optionally, the weight and/or value can be used for comparing with the corresponding predictions output by the corresponding models to identify errors, and modifying the respective prediction models accordingly.

In another example, an emissions prediction system includes a controller configured to receive aircraft data from a non-proprietary database and flight position data from one or more non-proprietary sources, along with tangible, non-transitory computer readable storage media storing both a weight prediction model and an emissions prediction model. The controller is programmed to input the received data into the weight prediction model to generate a gross weight prediction and subsequently input the aircraft data, the flight position data, and the gross weight prediction into the emissions prediction model to yield an emissions prediction. The system may further automatically change the flight of the aircraft based on the calculated emissions prediction. In some embodiments, the aircraft data includes metadata such as an engine type, fuel capacity, payload limit, age, operating empty weight, or seat count, and the flight position data includes details such as a flight origin, a flight destination, historical average flight time, or a historical average first level-off altitude. The controller can also be configured to receive a gross aircraft weight and an emissions value from an aircraft communications addressing and reporting system, compare these received values with the predictions to detect errors, and modify the prediction models as needed.

In yet another example, a method includes receiving non-proprietary aircraft metadata and automatic dependent surveillance-broadcast position data for one or more flights of an aircraft, calculating a gross weight prediction by processing this information using a weight prediction model, and then calculating an emissions prediction by inputting the aircraft metadata, flight position data, and the gross weight prediction into an emissions prediction model. In some implementations, the flight position data includes a historical average first level-off altitude for flights between a flight origin and a flight destination. This method may further involve receiving a gross aircraft weight and an emissions value from an aircraft communications addressing and reporting system, comparing these values with the respective predictions to identify discrepancies, and modifying the weight and emissions prediction models based on the identified errors. These and other features will be more fully appreciated from the detailed description that follows.

### BRIEF DESCRIPTION OF THE DRAWINGS

Figure 1 is a block diagram of an emissions prediction system integrating non-proprietary and proprietary databases with end user systems.
Figure 2 is a flow chart diagram illustrating a method for predicting aircraft emissions using non-proprietary data.
Figure 3 is a schematic diagram illustrating the architecture of an ML/AI system for aircraft emissions prediction.

### DETAILED DESCRIPTION OF THE DISCLOSURE

The foregoing summary, as well as the following detailed description of certain examples will be better understood when read in conjunction with the appended drawings. As used herein, an element or step recited in the singular and preceded by the word "a" or "an" should be understood as not necessarily excluding the plural of the elements or steps. Further, references to "one example" are not intended to be interpreted as excluding the existence of additional examples that also incorporate the recited features. Moreover, unless explicitly stated to the contrary, examples "comprising" or "having" an element or a plurality of elements having a particular condition can include additional elements not having that condition.

The systems and methods described herein address the challenges in estimating emissions (e.g., greenhouse gases such as CO₂; nitrogen oxides; carbon monoxide; unburned hydrocarbons; particulate matters; and/or sulfur dioxides) described above by providing a solution for estimating aircraft emissions using non-proprietary data and predictive modeling. The approach integrates publicly available aircraft metadata and position data (such as Automatic Dependent Surveillance-Broadcast (ADS-B) position data) to calculate a gross weight prediction of an aircraft. This prediction is then used as an input into an emissions prediction model, which provides a precise emissions estimation for the aircraft without reliance on proprietary information. By leveraging non-proprietary data sources, the systems and methods offer a scalable solution that can be applied at various levels of granularity, from individual flights to entire fleets, thus facilitating accurate emissions assessments for a wide range of stakeholders.

Non-proprietary data refers to information that is publicly accessible and not owned or controlled by any individual or organization, allowing the information to be freely used, shared, and distributed without restrictions. This type of data is typically available from open sources, such as public databases, government publications, or third-party vendors, and does not require special permissions or agreements for access. In the context herein, non-proprietary data is used to estimate aircraft emissions without relying on confidential or proprietary datasets from airlines or manufacturers. One example of non-proprietary data is ADS-B data. Proprietary data, on the other hand, refers to information that is owned by an individual or organization and is protected by intellectual property rights or confidentiality agreements. This type of data is not publicly available and is often considered a trade secret, giving the owner a competitive advantage. Access to proprietary data is typically restricted to authorized personnel, and its use is governed by specific legal agreements to prevent unauthorized disclosure or use. One example of proprietary data is Aircraft Communications Addressing and Reporting System (ACARS) data.

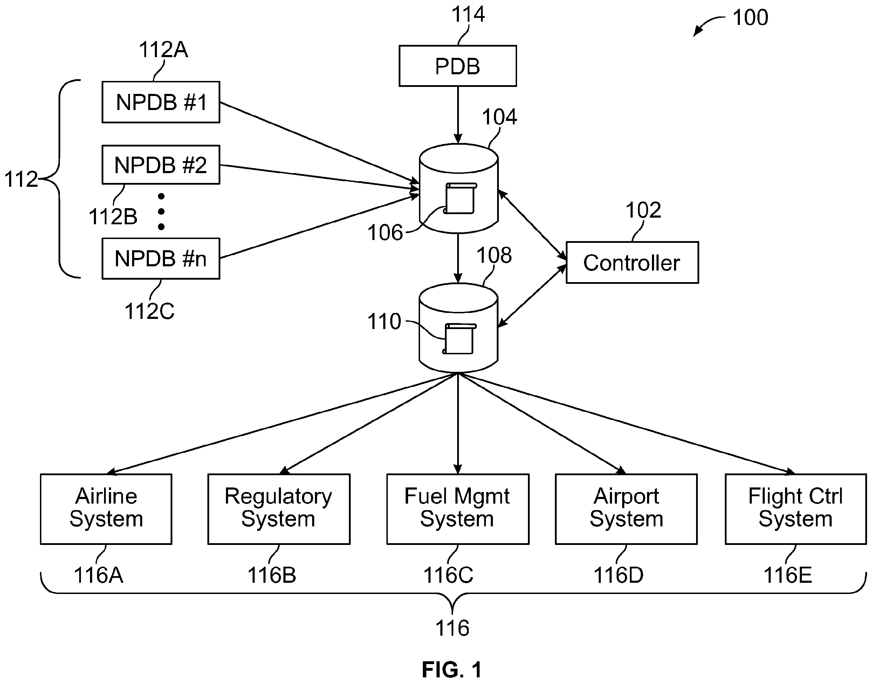

Figure 1 is a block diagram of one example of an emissions prediction system 100. The emissions prediction system 100 integrates non-proprietary and proprietary databases with end user systems 116. The emissions prediction system 100 estimates aircraft emissions using a combination of non-proprietary and proprietary data sources. The system 100 includes a controller 102 that controls flow of data and execution of predictive models. The controller 102 represents hardware circuitry that includes and/or is connected with one or more processors (such as one or more integrated circuits, field programmable gate arrays, application specific integrated circuits, etc.) that perform the operations described herein in connection with the controller 102. The controller 102 receives or obtains data from various databases and directs this data to the appropriate computational models stored in memory components of the system 100. The controller 102 functions as the central processing unit of the system 100 to ensure that data is accurately processed and predictions are efficiently generated.

A first computer memory 104 of the emissions prediction system 100 represents a tangible and non-transitory computer readable storage medium, such as one or more computer hard drives, solid state drives, flash memories, optical discs, magnetic tapes, or the like. The first computer memory 104 stores a gross weight prediction model 106. This memory 104 is responsible for holding the algorithms and data structures needed for predicting the gross weight of an aircraft based on input data. The gross weight prediction model 106 uses inputs from one or more non-proprietary databases 112 (e.g., databases 112A-C and shown as "NPDB" in Figure 1), which include various datasets such as aircraft metadata and flight position data. The model 106 processes this information to generate a gross weight prediction, which is a significant input for subsequent emissions calculations.

While three non-proprietary databases 112 are shown, alternatively, fewer or more databases 112 may be accessed. The non-proprietary databases 112 represent computer memories in one example, and send the data stored therein and/or allow access to the data stored therein. These databases 112 offer publicly accessible information such as aircraft specifications, flight paths, and historical flight data. The data from these sources is utilized to support the predictive models, allowing the system 100 to function without reliance on proprietary data limitations. The incorporation of multiple non-proprietary databases contributes to a thorough dataset for precise predictions. Examples of the non-proprietary databases 112 include memories or databases of the Federal Aviation Administration (e.g., the Federal Aviation Administration Registry), the European Union Aviation Safety Agency (e.g., the type certificate data sheets), the International Civil Aviation Organization, National Civil Aviation Authorities, Flightradar24, FlightAware, the ADS-B Exchange, Cirium (formerly FlightGlobal), JetNet, AMSTAT, the OpenSky Network, and AeroAPI by AviationStack.

A second computer memory 108 contains an emissions prediction model 110, which is responsible for estimating the emissions output of an aircraft. This model considers the gross weight prediction from the gross weight prediction model 106, along with additional data inputs, to calculate emissions. The emissions prediction model 110 is designed to manage complex data interactions and provide accurate emissions estimates for regulatory compliance and environmental assessments, among other uses.

A proprietary database 114 ("PDB" in Figure 1), while not the primary data source in one embodiment, is used to enhance the accuracy of the predictions by providing additional data that may not be available in the non-proprietary databases. This database 114 can include sensitive or proprietary information that, when combined with non-proprietary data, can refine the predictive models and improve the precision of the emissions estimates. As described herein, this additional data can enhance the accuracy of the predictions by training or refining the models against a ground truth. For example, the actual gross weight of an aircraft can be obtained from a proprietary database 114 and compared to a gross weight prediction output by a model. This comparison can be used to identify the presence of an error and modify the model to improve future gross weight predictions. As another example, the actual emissions generated by an aircraft can be obtained from a proprietary database 114 and compared to an emissions prediction output by a model. This comparison can be used to identify the presence of an error and modify the model to improve future emission predictions.

The controller 102 accurately estimates aircraft emissions for aircraft during a current flight of the aircraft, a prior flight of the aircraft, and/or a future or upcoming flight of the aircraft. The emissions are predicted by the controller 102 integrating data from the non-proprietary databases 112 such as ADS-B data and aircraft metadata with the gross weight prediction model 106. The non-proprietary data from the databases 112 includes ADS-B position data or information, such as the origin location of a flight, the destination location of the flight, an average time for a flight from the origin location to the destination location, and/or the average first level-off altitude for a flight from the origin location to the destination location.

The non-proprietary data are input into the model 106 and the model 106 includes equations, mathematical relationships, algorithms, etc. that calculate a prediction of the gross weight of an aircraft for a flight between the origin and destination locations. With respect to the ADS-B position data obtained from the databases 112, the origin and destination locations are used by the model 106 and controller 102 to calculate the distance traveled by the aircraft during the flight from the origin location to the destination location. This distance is calculated based to how far the locations are from each other and the different altitudes that the aircraft flies to travel from the origin location to the destination location. The model 106 includes equations, mathematical relationships, algorithms, etc. that equate different distances traveled by different aircraft for different flights to different amounts of fuel required to be carried by the aircraft to complete the flights. Longer flights, flights requiring higher altitudes, and/or flights requiring more changes in altitude require consumption of more fuel by some aircraft (relative to shorter flights, lower altitudes, and/or fewer changes in altitude).

Similarly, the average time for flights from the origin location to the destination location is obtained by the controller 102 from one or more of the non-proprietary databases 112 and/or is calculated by the controller 102 from flight times stored in one or more of the databases 112. The model 106 equates different average flight times for flights to different amounts of fuel required to be carried by the aircraft to complete the flights. Longer flights tend to require consumption of more fuel by some aircraft (relative to shorter flights).

The average first level-off altitude is obtained by the controller 102 from one or more of the non-proprietary databases 112 and/or is calculated by the controller 102 from altitudes of flights stored in one or more of the databases 112. The average first level-off altitude represents the average altitude at which the aircraft (or the same make and/or model of the aircraft for which the emissions prediction is being made) stops ascending or climbing after takeoff from the origin location and maintains the altitude during the flight. Some flights have higher first level-off altitudes than other flights due to geographic features (e.g., surrounding mountains), location features (e.g., tall buildings), airport features (e.g., nearby flight paths of other aircraft), etc. This often requires more rapid accelerations and fuel burn of the aircraft to reach the higher first level-off altitudes when compared to flights with lower first level-off altitudes. The model 106 equates different amounts of fuel required to be carried by aircraft with different higher first level-off altitudes.

With respect to the aircraft metadata, the controller 102 obtains or receives this information from one or more of the databases 112. The aircraft metadata includes information such as engine types of different aircraft, fuel capacities of different aircraft, maximum payloads that different aircraft are able to carry, different ages of the aircraft, operating empty weights of different aircraft, and the numbers of seats onboard different aircraft. The model 106 equates different values for this metadata with different weights of the aircraft. For example, aircraft having certain types of engines (e.g., larger engines or more engines) tend to be heavier than aircraft with smaller or fewer engines, and aircraft having larger fuel capacities tend to be heavier when carrying more fuel relative to aircraft with smaller fuel capacities (which is calculated using the model 106 based on the ADS-B position data as described above). With respect to the maximum payloads and the number of seats, the model 106 assumes that a designated percentage or fraction of the maximum payload and/or number of seats are occupied with a designated weight. For example, the model 106 assumes that 80-84% of the maximum payload of each aircraft is holding cargo and/or that 80-84% of the seats are occupied with an average weight of a human (which is based, in turn, on the origin location of the flight as different locations have different average human weights). With respect to the aircraft age, some older aircraft are heavier than some newer aircraft per the model 106. Finally, the operating empty weight of the aircraft is directly related to the gross weight of the aircraft by the model 106.

The model 106 includes equations, mathematical relationships, algorithms, etc. that equate different amounts of fuel carried by the aircraft to different weights of the fuel (as calculated using the model 106 and the ADS-B position data) and that equate different values of the aircraft metadata with different weights. The model 106 is used to combine the fuel weight and the weight from the aircraft metadata with a gross weight prediction.

The controller 102 refines or re-trains the model 106 in one example. The controller 102 may have access to proprietary data for an aircraft, such as the actual gross weight of the aircraft for a flight, from the proprietary database 114 (e.g., from an ACARS database). The controller 102 compares the actual gross weight of the aircraft for a flight with the predicted gross weight that is output by the model 106 (with the same metadata and position data that applies to the same aircraft and the same flight for which the actual gross weight of the aircraft applies). If these two values differ (or differ by at least a threshold amount, such as 3%), the controller 102 calculates an error. This error is the difference between the predicted and actual gross weights. The error is used by the controller 102 to refine or re-train the model 106. For example, one or more of the equations, mathematical relationships, or algorithms that convert input aircraft metadata and/or ADS-B data into the gross weight prediction are modified. The controller 102 then re-inputs the same non-proprietary data previously used to predict the gross weight of the aircraft back into the model 106 and obtains another gross weight prediction. This additional prediction is compared with the actual gross weight to determine whether there is an error. If another error is found, the controller 102 refines or re-trains the model 106, obtains another gross weight prediction, determines whether there is another error, and so on. The controller 102 iteratively repeats this process until the error is eliminated or the error is reduced (e.g., to less than the threshold amount).

The controller 106 inputs the predicted gross weight of an aircraft into the emissions prediction model 110, along with non-proprietary data obtained or received from the databases 112. The emissions are predicted by the controller 102 using the model 110 to integrate data from the non-proprietary databases 112 (such as the ADS-B data and the aircraft metadata described above) with the gross weight prediction that is output from the model 106.

The non-proprietary data and gross weight prediction are input into the model 110 and the model 110 includes equations, mathematical relationships, algorithms, etc. that calculate a prediction of the emissions output by an aircraft for a flight between the origin and destination locations. With respect to the ADS-B position data obtained from the databases 112, the origin and destination locations are used by the model 106 and controller 102 to calculate the distance traveled by the aircraft during the flight from the origin location to the destination location. The model 110 includes equations, mathematical relationships, algorithms, etc. that equate different distances traveled by different aircraft for different flights to different amounts of fuel consumed by the aircraft to complete the flights. Longer flights, flights requiring higher altitudes, and/or flights requiring more changes in altitude require consumption of more fuel by some aircraft (relative to shorter flights, lower altitudes, and/or fewer changes in altitude).

Similarly, the average time for flights from the origin location to the destination location is obtained by the controller 102 from one or more of the non-proprietary databases 112 and/or is calculated by the controller 102 from flight times stored in one or more of the databases 112. The model 110 equates different average flight times for flights to different amounts of fuel consumed by the aircraft to complete the flights. Longer flights tend to require consumption of more fuel by some aircraft (relative to shorter flights).

The average first level-off altitude is obtained by the controller 102 from one or more of the non-proprietary databases 112 and/or is calculated by the controller 102 from altitudes of flights stored in one or more of the databases 112. The model 110 equates different amounts of fuel consumed by the aircraft with different higher first level-off altitudes. For example, higher first level-off altitudes are associated with increased fuel consumption relative to lower first level-off altitudes. As another example, heavier aircraft may level off earlier than lighter aircraft to adjust for lower climb performance. Lighter aircraft may climb continuously to the cruising altitude. There is a strong relationship between the initial level-off altitude and the gross weight because the gross weight affects the thrust-to-weight ratio and climb efficiency of the aircraft.

With respect to the aircraft metadata, the model 110 equates different values for this metadata with different amounts of fuel consumption by the aircraft. For example, aircraft having certain types of engines (e.g., larger engines or more engines) tend to consume more fuel or consume fuel at a faster rate compared with aircraft having smaller or fewer engines. With respect to the aircraft age, some older aircraft are less fuel efficient and/or produce more emissions than newer aircraft.

The model 110 includes equations, mathematical relationships, algorithms, etc. that equate the above non-proprietary data with different amounts of fuel consumption, as well as equate gross weight predictions with different amounts of fuel consumption. The model 110 uses these equations, relationships, and/or algorithms to output an emissions prediction. This prediction indicates the amount (e.g., in terms of weight, mass, volume percentage, or the like) and optionally the type of emissions produced by the aircraft during the flight.

The controller 102 refines or re-trains the model 110 in one example. The controller 102 may have access to proprietary data for an aircraft, such as the actual CO₂ emissions from the aircraft during a flight obtained from the proprietary database 114 (e.g., an ACARS database). The controller 102 compares the actual emissions of the aircraft for the flight with the predicted emissions that is output by the model 110 (with the same metadata and position data that applies to the same aircraft and the same flight for which the actual emissions of the aircraft applies). If these two values differ (or differ by at least the threshold amount), the controller 102 calculates an error. This error is the difference between the predicted and actual emissions. The error is used by the controller 102 to refine or re-train the model 110. For example, one or more of the equations, mathematical relationships, or algorithms that convert input aircraft metadata and/or ADS-B data into the emissions prediction are modified. The controller 102 then re-inputs the same non-proprietary data previously used to predict the emissions of the aircraft back into the model 110 and obtains another emissions prediction. This additional prediction is compared with the actual emissions to determine whether there is an error. If another error is found, the controller 102 refines or re-trains the model 110, obtains another emissions prediction, determines whether there is another error, and so on. The controller 102 iteratively repeats this process until the error is eliminated or the error is reduced (e.g., to less than the threshold amount).

The systems 100 is able to achieve significant precision with emissions prediction on a global level or level of a fleet of aircraft, down to individual flights or aircraft (e.g., to individual flights or tail numbers) by incorporating all the variables and training the models 106, 110 separately for individual aircraft types. For example, the models 106, 110 are trained (or there may be separate models 106, 110) for each different make and model of aircraft, for each individual aircraft (e.g., each tail number), for each fleet or group of aircraft, or the like. The emissions predictions are made purely with non-proprietary data without resorting to any information from the operators of the aircraft.

One or more end user systems 116 (e.g., systems 116A-E) represent various stakeholders that benefit from the emissions prediction system 100. These systems 116 receive the output from the emissions prediction model 110 and use this information for a range of applications, such as optimizing flight operations, ensuring regulatory compliance, managing fuel distribution, and assessing environmental impact. The integration of these end user systems 116 provides for practical applications of the emissions prediction system 100 in real-world scenarios. The end user systems 116 include an airline system 116A that represents one or more airlines or airline companies (or computerized systems of the airlines). The airline system 116A receives the emission prediction for aircraft and/or flights, and uses this information to assess environmental performance of different aircraft and engine configurations, track and benchmark emissions against competitors for advertising purposes, or the like. Optionally, the airline system 116A modifies flight paths or schedules of aircraft (including which aircraft fly which routes) based on the emissions predictions (e.g., to lessen the amount of emissions predicted to be generated).

The end user systems 116 include a regulatory system 116B that represents one or more regulatory bodies or groups (or computerized systems of the regulatory bodies or groups). The regulatory system 116B receives the emissions predictions from airlines and uses the predictions to identify airlines that are following or not following emissions regulations or laws. The regulatory system 116B can prevent continued operation of airlines, levy fines, or the like, based on the predicted emissions that are found to violate regulations.

The end user systems 116 include a fuel management system 116C that represents one or more fuel vendors (or computerized systems of the fuel vendors). The fuel management system 116C receives the emissions predictions from airlines and uses the predictions to estimate fuel demand by observing emissions in different regions. This leads to more efficient fuel pricing and distribution. For example, a fuel vendor can determine that emissions are increasing for a geographic area of a country and increase distribution of the fuel to that area. This can prevent fuel shortages in that area.

The end user systems 116 include an airport system 116D that represents one or more airports (or computerized systems of the airports). The airport system 116D receives the emissions predictions and examines the emissions predictions to identify impacts of different operational practices on overall emissions generated at or near the airport. The airport system 116D optionally changes practices to reduce fuel burn and emission generation, such as by changing flight schedules, runway usage, or the like.

The end user systems 116 include a flight control system 116E that represents one or more systems onboard an aircraft that automatically control various operations of the aircraft. In one example, the flight control system 116E represents an automatic flight control system that automatically controls the flight path of an aircraft after takeoff, during cruise, and optionally during landing. In another example, the flight control system 116E represents a flight management system (FMS) that automates navigation and planning of flights of the aircraft. In another example, the flight control system 116E represents an auto throttle or auto thrust system onboard the aircraft that automatically controls engine power automatically. The controller 102 obtains the emission prediction from the model 110 during flight of an aircraft. The controller 102 or the flight control system 116E onboard the same aircraft examines the emission prediction and decides whether to alter flight operations of the aircraft based on the emissions prediction. For example, if the emissions prediction exceeds a designated upper threshold (which can be associated with a geographic area or volume through which the aircraft is flying, with different areas or volumes associated with different upper thresholds), then the flight control system 116E automatically changes flight of the aircraft to reduce the emissions (or reduce the emissions prediction). The flight control system 116E reduces speed, reduces altitude, or the like, responsive to receiving the emissions prediction. This helps the aircraft reduce emissions in real-time.

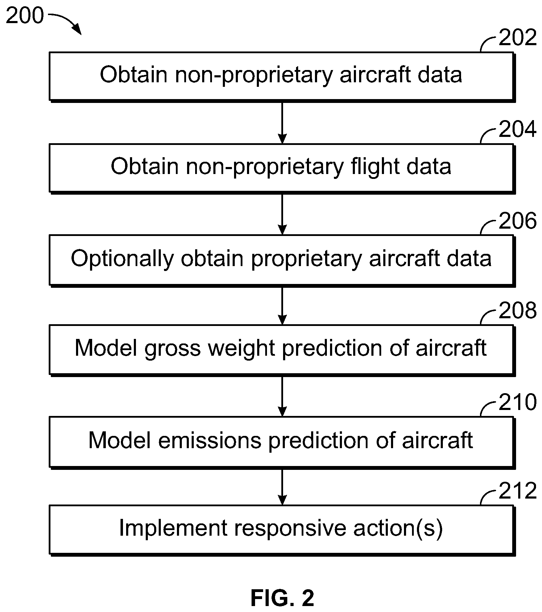

Figure 2 illustrates a flow chart of one example of a method 200 for predicting aircraft emissions. The method 200 uses publicly available data sources and advanced modeling techniques to accurately predict emissions for flight of an aircraft. The method 200 represents operations performed by the controller 102 in one example. The operations of the method 200 can be performed in the order shown or in another order. Additionally, two or more of the operations 200 can be performed at the same time instead of in a sequential order.

At 202, non-proprietary aircraft data is obtained. This data includes aircraft metadata such as engine type, fuel capacity, maximum payload, aircraft age, operating empty weight, and the number of seats. These parameters are important for understanding the baseline characteristics of the aircraft, which directly influence the weight and emissions profile of the aircraft. The non-proprietary nature of this data ensures that the information is readily accessible from public databases or third-party vendors, facilitating scalability and broad applicability of the method 200.

At 204, non-proprietary flight data is obtained. This data complements the aircraft data by providing contextual information about the flight. This data includes details such as the flight origin, destination, historical average flight time, and historical average first level-off altitude. These parameters are important for modeling the operational aspects of the flight, such as the expected fuel load and initial climb performance, which are influenced by the gross weight of the aircraft. The integration of this flight data with the aircraft data enables a more comprehensive understanding of the factors affecting emissions. Alternatively, 204 may be performed before 202, or 202 and 204 can be performed simultaneously or concurrently.

At 206, obtaining proprietary aircraft data is optionally obtained. The proprietary data can be obtained to refine or re-train one or both of the models. As described above, the predicted gross weight calculated from non-proprietary data is compared with the actual gross weight obtained from proprietary data and, if significant error is identified, the model 106 is modified to reduce or eliminate the error. Similarly, the predicted emissions calculated from non-proprietary data is compared with the actual emissions obtained from proprietary data and, if significant error is identified, the model 110 is modified to reduce or eliminate the error. Alternatively, the method 200 does not include 206. In another example, 206 is performed before, between, or the same time as 202 and/or 204.

At 208, the gross weight of the aircraft is predicted. The gross weight can be predicted by inputting non-proprietary aircraft and flight data into the model 106. This prediction plays an important role in the emissions estimation process, as the gross weight directly impacts the amount of fuel consumed and, as a result, the emissions produced. The weight prediction model utilizes machine learning techniques to analyze the input data and generate an accurate estimate of the gross weight of the aircraft, which serves as an important input for the emissions prediction model.

At 210, the emissions prediction of the aircraft is modeled. The amount of emissions generated by the aircraft is predicted using the gross weight prediction and the non-proprietary aircraft and flight data. The model 110 is used to predict the emissions, with the model 110 using machine learning techniques to analyze the input data and generate an accurate estimate of the emissions, which plays a significant role in regulatory compliance, environmental assessments, and operational optimization. The emissions prediction model is designed to be adaptable and scalable, allowing application to a wide range of aircraft types and flight scenarios.

At 212, one or more responsive actions are implemented based on the emissions prediction. These actions may include adjusting flight operations, optimizing fuel distribution, or ensuring compliance with environmental regulations. By providing accurate and timely emissions predictions, the method enables stakeholders to make informed decisions that enhance operational efficiency and reduce environmental impact.

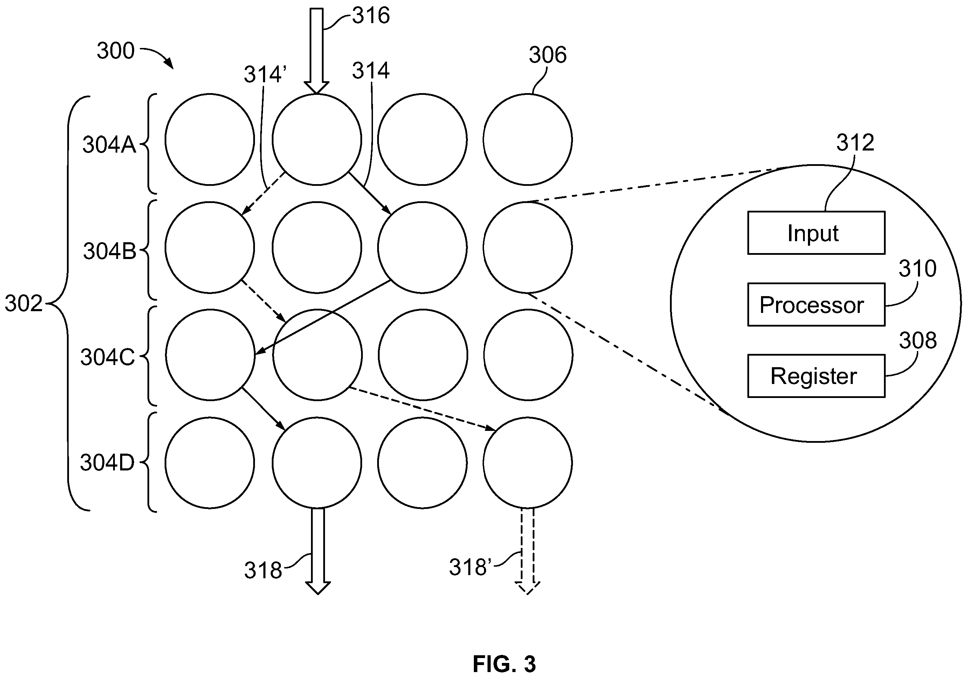

Figure 3 illustrates one example of a machine learning (ML)/artificial intelligence (AI) system 300. The ML/AI system 300 represents each of the models 106, 110 in one embodiment. The ML/AI system 300 can be embodied in one or more application-specific integrated circuits (ASICs) for an artificial neural network (ANN). The ML/AI system 300 (or the ASIC(s)) can includes a series 302 of layers 304A-D, each comprising one or more artificial neurons 306 arranged in one or more neuron arrays or arrangements. While four neurons 306 are shown in each layer 304A-D and four layers 304A-D are shown, alternatively, a different number of neurons 306 may be in one or more of the layers 304A-D and/or there may be a different number of layers 304A-D.

The ML/AI system 300 may include the neurons 306 arranged in an input layer 304A, an output layer 304D, and two or more fully connected hidden or intermediate layers 304B, 304C between the input and output layers 304A, 304D. Each neuron 306 can include or represent a register 308, a microprocessor 310, and at least one input 312. Optionally, the microprocessors 310 can be embodied in the controller 102. The neurons 306 can generate output based on one or more activation functions. The neurons 306 can receive input from another neuron 306 (e.g., the output from one neuron 306 can be the input for another neuron 306). This input also can include a set of weights. The neurons 306 can be connected with each other via synaptic circuits 314, 314'. The synaptic circuits 314, 314' can include or represent memories for storing synaptic weights.

One or more neurons 306 in the input layer 304A of the ML/AI system 300 can receive an input 316 into the ML/AI system 300. The input 316 can include, for example, the non-proprietary data input into the gross weight prediction model 106, or the non-proprietary data and the gross weight prediction input into the emissions prediction model 110. The neurons 306 receive this input data 316 via the input(s) 312 of the neurons 306 in the input layer 304A. The neurons 306 receive the input data 316, apply one or more mathematical equations, relationships, or algorithms stored in the registers 308 (and that include the weights) to generate an output. These equations, relationships, or algorithms can be based on empirically studied relationships between the different non-proprietary data and the gross weights of aircraft, or between (a) the non-proprietary data and the gross weight prediction and (b) the predicted emissions. The synaptic circuits 314, 314', weights stored in the synaptic circuits 314, 314', and/or the mathematical relationships between the neurons 306 can define a model that is used to predict the gross weight or the emissions. The processors 310 of the neurons 306 apply the equations/relationships and can pass the output to another neuron 306 in the same layer 304A or in a different layer 304B, 304C. The output from one neuron 306 is passed along a synaptic circuit 314 to another neuron 306 and is used as input to this other neuron 306. This process continues until one or more neurons 306 in the output layer 304D generate an output 318 from the ML/AI system 300. As described above, this output 318 is the predicted gross weight for the model 106, and is the predicted emissions for the model 110.

During training of the AI/ML system 300, labeled data may be provided as the input data 316 to the AI/ML system 300. The labeled data can include non-proprietary or proprietary data described herein. For example, the labeled data can identify the predicted gross weight for the model 106 or the predicted emissions for the model 110. The neurons 306 process the input data 316 to generate the training output of the AI/ML system 300. This training output can be the predicted gross weight or the predicted emissions. This output can then be compared to the actual gross weight or the actual emissions.

Feedback can be provided to the AI/ML system 300 in the form of a calculated error or other indication of the differences between the predicted and actual gross weight, or between the predicted and actual emissions, as described above. Based on this error, the neurons 306 can change one or more of the synaptic circuits 314 that connect the neurons 306, the weights applied by one or more of the neurons 306, and/or the mathematical relationships between the neurons 306. For example, some synaptic circuits 314 can be changed to modified synaptic circuits 314' such that the same input 316 would result in different neurons 306 receiving input and passing output to other neurons and generating a different output 318' from the AI/ML system 300. As a result, changing one or more of these weights or relationships (e.g., synaptic circuits 314, 314') also can change the predicted gross weight or the predicted emissions that are output by the models 106, 110.

During post-training iterations of operation of the AI/ML system 300, additional feedback can be provided to the AI/ML system 300 based on errors in the predicted gross weight or the predicted emissions. The AI/ML system 300 can repeatedly receive such feedback, modify one or more weights and/or synaptic circuits, etc. so that the AI/ML system 300 repeatedly changes to improve and reduce error in predicting gross weights or emissions of aircraft.

Also provided are the following illustrative, non-exhaustive examples of the subject-matter encompassed herein, which relate to:

A method which comprises: receiving aircraft data from a first non-proprietary database; receiving flight position data from one or more of the first non-proprietary database or a second non-proprietary database; calculating a gross weight prediction of an aircraft using the aircraft data and the flight position data that are input into a weight prediction model; and calculating an emissions prediction of the aircraft using the aircraft data, the flight position data, and the gross weight prediction that are input into an emissions prediction model.

The method described in the immediately preceding paragraph, further comprising: automatically changing flight of the aircraft based on the emissions prediction that is calculated.

The method described in the first of the two immediately preceding paragraphs wherein the aircraft data and the flight position data are publicly available information.

The method described in the first of the three immediately preceding paragraphs, wherein the aircraft data includes aircraft metadata.

The method described in the immediately preceding paragraph, wherein the aircraft metadata includes one or more of an aircraft engine type, a fuel capacity of the aircraft, a payload limit of the aircraft, an age of the aircraft, an operating empty weight of the aircraft, or a number of seats onboard the aircraft.

The method described in the first of the five immediately preceding paragraphs, wherein the flight position data includes automatic dependent surveillance-broadcast (ADS-B) position data.

The method described in the immediately preceding paragraph, wherein the ADS-B position data includes one or more of a flight origin location, a flight destination location, or a historical average flight time from the flight origin location to the flight destination location.

The method described in the first of the two immediately preceding paragraphs, wherein the ADS-B position data includes a historical average first level-off altitude for historical flights between the flight origin location to the flight destination location.

The method described in the first of the eight immediately preceding paragraphs, further comprising: receiving a gross aircraft weight from an aircraft communications addressing and reporting system (ACARS); comparing the gross aircraft weight with the gross weight prediction to identify an error; and modifying the weight prediction model using the error.

The method described in the first of the nine immediately preceding paragraphs, further comprising: receiving an emissions value from an aircraft communications addressing and reporting system (ACARS); comparing the emissions value with the emissions prediction to identify an error; and modifying the emissions prediction model using the error.

An emissions prediction system, which comprises: a controller configured to receive aircraft data from a first non-proprietary database and to receive flight position data from one or more of the first non-proprietary database or a second non-proprietary database; and one or more tangible and non-transitory computer readable storage media storing a weight prediction model and an emissions prediction model, the controller configured to input the aircraft data and the flight position data into the weight prediction model, the weight prediction model configured to output a gross weight prediction of an aircraft, the controller configured to input the aircraft data, the flight position data, and the gross weight prediction into the emissions prediction model, the emissions prediction model configured to output an emissions prediction of the aircraft.

The emissions prediction system described in the immediately preceding paragraph, wherein the controller is configured to automatically change flight of the aircraft based on the emissions prediction that is calculated.

The emissions prediction system described in the first of the two immediately preceding paragraphs, wherein the aircraft data includes one or more of an aircraft engine type, a fuel capacity of the aircraft, a payload limit of the aircraft, an age of the aircraft, an operating empty weight of the aircraft, or a number of seats onboard the aircraft.

The emissions prediction system described in the first of the three immediately preceding paragraphs, wherein the flight position data includes one or more of a flight origin location, a flight destination location, or a historical average flight time from the flight origin location to the flight destination location.

The emissions prediction system described in the first of the four immediately preceding paragraphs, wherein the flight position data includes a historical average first level-off altitude for historical flights between the flight origin location to the flight destination location.

The emissions prediction system described in the first of the five immediately preceding paragraphs, wherein the controller is configured to receive a gross aircraft weight from an aircraft communications addressing and reporting system (ACARS), compare the gross aircraft weight with the gross weight prediction to identify an error, and modify the weight prediction model using the error.

The emissions prediction system described in the first of the six immediately preceding paragraphs, wherein the controller is configured to receive an emissions value from an aircraft communications addressing and reporting system (ACARS), compare the emissions value with the emissions prediction to identify an error, and modify the emissions prediction model using the error.

A method, which comprises: receiving non-proprietary aircraft metadata for an aircraft and non-proprietary automatic dependent surveillance-broadcast (ADS-B) position data for one or more flights of the aircraft; calculating a gross weight prediction of the aircraft using the aircraft data and the flight position data that are input into a weight prediction model; and calculating an emissions prediction of the aircraft using the aircraft data, the flight position data, and the gross weight prediction that are input into an emissions prediction model.

The method described in the immediately preceding paragraph, wherein the ADS-B position data includes a historical average first level-off altitude for historical flights between the flight origin location to the flight destination location.

The method described in the first of the two immediately preceding paragraphs, further comprising: receiving a gross aircraft weight from an aircraft communications addressing and reporting system (ACARS); comparing the gross aircraft weight with the gross weight prediction to identify a first error; modifying the weight prediction model using the first error; receiving an emissions value from an aircraft communications addressing and reporting system (ACARS); comparing the emissions value with the emissions prediction to identify a second error; and modifying the emissions prediction model using the second error.

While various spatial and directional terms, such as top, bottom, lower, mid, lateral, horizontal, vertical, front and the like can be used to describe examples of the present disclosure, it is understood that such terms are merely used with respect to the orientations shown in the drawings. The orientations can be inverted, rotated, or otherwise changed, such that an upper portion is a lower portion, and vice versa, horizontal becomes vertical, and the like.

As used herein, a structure, limitation, or element that is "configured to" perform a task or operation is particularly structurally formed, constructed, or adapted in a manner corresponding to the task or operation. For purposes of clarity and the avoidance of doubt, an object that is merely capable of being modified to perform the task or operation is not "configured to" perform the task or operation as used herein.

It is to be understood that the above description is intended to be illustrative, and not restrictive. For example, the above-described examples (and/or aspects thereof) can be used in combination with each other. In addition, many modifications can be made to adapt a particular situation or material to the teachings of the various examples of the disclosure without departing from their scope as defined by the appended claims. While the dimensions and types of materials described herein are intended to define the aspects of the various examples of the disclosure, the examples are by no means limiting and are exemplary examples. Many other examples will be apparent to those of skill in the art upon reviewing the above description. The scope of the various examples of the disclosure should, therefore, be determined with reference to the appended claims. In the appended claims and the detailed description herein, the terms "including" and "in which" are used as the plain-English equivalents of the respective terms "comprising" and "wherein." Moreover, the terms "first," "second," and "third," etc. are used merely as labels, and are not intended to impose numerical requirements on their objects.

This written description uses examples to disclose the various examples of the disclosure, including the best mode, and also to enable any person skilled in the art to practice the various examples of the disclosure, including making and using any devices or systems and performing any incorporated methods. The patentable scope of the various examples of the disclosure is defined by the claims, and can include other examples that occur to those skilled in the art. Such other examples are intended to be within the scope of the claims if the examples have structural elements that do not differ from the literal language of the claims, or if the examples include equivalent structural elements with insubstantial differences from the literal language of the claims.

## Claims

1. A method (200) comprising:
receiving aircraft data;
receiving flight position data;
calculating a gross weight prediction of an aircraft using the aircraft data and the flight position data that are input into a weight prediction model (106) ; and
calculating an emissions prediction of the aircraft using the aircraft data, the flight position data, and the gross weight prediction that are input into an emissions prediction model (110).

2. The method (200) of claim1, wherein the aircraft data is received from a first non-proprietary database (114), and the flight position data is received from one or more of the first non-proprietary database (114) and a second non-proprietary database (114).

3. The method according to claim 1, wherein the aircraft data comprises non-proprietary aircraft metadata for the aircraft, and the flight position data comprises non-proprietary automatic dependent surveillance-broadcast, ADS-B, position data for one or more flights of the aircraft.

4. The method (200) of claim 3, further comprising:
receiving a gross aircraft weight from an aircraft communications addressing and reporting system, ACARS;
comparing the gross aircraft weight with the gross weight prediction to identify a first error;
modifying the weight prediction model (106) using the first error;
receiving an emissions value from the ACARS;
comparing the emissions value with the emissions prediction to identify a second error; and
modifying the emissions prediction model (110) using the second error.

5. The method (200) of claim 1, further comprising:
automatically changing flight of the aircraft based on the emissions prediction that is calculated.

6. The method (200) of claim 1, wherein the aircraft data and the flight position data are publicly available information.

7. The method (200) of claim 1, wherein the aircraft data includes aircraft metadata.

8. The method (200) of claim 7, wherein the aircraft metadata includes one or more of an aircraft engine type, a fuel capacity of the aircraft, a payload limit of the aircraft, an age of the aircraft, an operating empty weight of the aircraft, and a number of seats onboard the aircraft.

9. The method (200) of claim 1, wherein the flight position data includes automatic dependent surveillance-broadcast, ADS-B, position data.

10. The method (200) of claim 1, wherein the flight position data includes one or more of a flight origin location, a flight destination location, and a historical average flight time from the flight origin location to the flight destination location.

11. The method (200) of claim 1, wherein the flight position data includes a historical average first level-off altitude for historical flights between the flight origin location to the flight destination location.

12. The method (200) of claim 1, further comprising:
receiving a gross aircraft weight from an aircraft communications addressing and reporting system, ACARS;
comparing the gross aircraft weight with the gross weight prediction to identify an error; and
modifying the weight prediction model (106) using the error.

13. The method (200) of claim 1, further comprising:
receiving an emissions value from an aircraft communications addressing and reporting system, ACARS;
comparing the emissions value with the emissions prediction to identify an error; and
modifying the emissions prediction model (110) using the error.

14. An emissions prediction system configured to implement a method according to claim 1, the emissions prediction system comprising:
a controller (102) configured to receive aircraft data from a first non-proprietary database (114) and to receive flight position data from one or more of the first non-proprietary database (114) and a second non-proprietary database (114); and
one or more tangible and non-transitory computer readable storage media storing a weight prediction model (106) and an emissions prediction model (110), the controller (102) configured to input the aircraft data and the flight position data into the weight prediction model (106), the weight prediction model (106) configured to output a gross weight prediction of an aircraft, the controller (102) configured to input the aircraft data, the flight position data, and the gross weight prediction into the emissions prediction model (110), the emissions prediction model (110) configured to output an emissions prediction of the aircraft.

15. The emissions prediction system of claim 14 further configured to implement a method according to any of claims 2 - 13.
